# EUROPÄISCHE PATENTANMELDUNG

(11) **EP 4 310 528 A1**
(43) Veröffentlichungstag der Anmeldung: **24.01.2024**
(21) Anmeldenummer: 23184897.9
(22) Anmeldetag: 12.07.2023
(51) Int. Cl.: G01R 33/02, G01R 33/04, G01R 33/3815, G01R 33/3873, G01R 33/3875, H01F 6/04

(54) **PASSIVE REDUZIERUNG VON TEMPERATURINDUZIERTEM SHIMDRIFT BEI NMR-MAGNETSYSTEMEN**

(30) Priorität: 21.07.2022 DE 102022207486
(71) Anmelder: Bruker Switzerland AG, 8117 Fällanden (CH)
(72) Erfinder: Mayer, Markus, 8625 Gossau (CH); Grossniklaus, Beat, 8173 Neerach (CH); Bovier, Pierre-Alain, 8050 Zürich (CH); Caminada, Rafael, 8185 Winkel (CH)
(74) Vertreter: Kohler Schmid Möbus Patentanwälte

(57) **Zusammenfassung**

Eine NMR-Apparatur mit einem Magnetspulensystem zur Erzeugung eines homogenen Magnetfelds, welches einen supraleitenden Magneten (1) umfasst, der im Kaltbereich eines Kryostaten innerhalb eines Vakuumbehälters (8) angeordnet ist, und welches ein Shimsystem (7) umfasst, das außerhalb des Vakuumbehälters angeordnete Shimelemente (6) enthält, wobei der Magnet über eine Magnetaufhängung (3) eine erste mechanische Verbindungsstelle (11) mit dem Vakuumbehälter aufweist, und wobei das Shimsystem über ein Positionierungselement (5) mit dem Vakuumbehälter eine zweite mechanische Verbindungsstelle (10; 12) aufweist, ist dadurch gekennzeichnet,
dass auf mindestens einem Abschnitt eines Pfades entlang des Vakuumbehälters von der ersten mechanischen Verbindungsstelle zur zweiten mechanischen Verbindungsstelle und/oder auf mindestens einem Abschnitt eines Pfades entlang des Positionierungselements von der zweiten mechanischen Verbindungsstelle zum Shimsystem nur Materialien eingesetzt sind, deren Wärmeausdehnungskoeffizient bei Betriebstemperatur kleiner ist als 5 ppm/K.

Damit kann die Magnetfeldhomogenität auch bei sich verändernden Temperaturverhältnissen innerhalb und im Umfeld der Apparatur weitestgehend stabil und konstant gehalten werden.

## Beschreibung

Die Erfindung betrifft eine NMR-Apparatur mit einem Magnetspulensystem zur Erzeugung eines homogenen Magnetfelds, welches einen supraleitenden Magneten umfasst, der im Kaltbereich eines Kryostaten innerhalb eines Vakuumbehälters angeordnet ist, und welches ein Shimsystem umfasst, das außerhalb des Vakuumbehälters angeordnete Shimelemente enthält, wobei der supraleitende Magnet über eine Magnetaufhängung eine erste mechanische Verbindungsstelle mit dem Vakuumbehälter aufweist, und wobei das Shimsystem über ein Positionierungselement mit dem Vakuumbehälter eine zweite mechanische Verbindungsstelle aufweist.

Eine solche NMR-Apparatur ist aus der Druckschrift DE 101 04 365 C1 (=Referenz [1]) bekannt geworden.

### Hintergrund der Erfindung

Die vorliegende Erfindung befasst sich ganz allgemein mit dem Bereich der Kernspinresonanz (nuclear magnetic resonance = "NMR"), insbesondere mit gekühlten, in der Regel im Betrieb supraleitenden NMR-Magnetsystemen, bei denen die Homogenität des NMR-Magnetfelds durch ein Shimsystem noch weiter verbessert wird.

Die NMR-Spektroskopie ist ein in der instrumentellen Analytik weitverbreitetes und leistungsfähiges Verfahren, mit dessen Hilfe bei einer zu untersuchenden Substanz, wie beispielsweise einem Kohlenwasserstoff oder einer bioanorganischen Komplexverbindung, die elektronische Umgebung einzelner Atome und der Wechselwirkung der einzelnen Atome mit den benachbarten Atomen untersucht werden kann. Auf diese Weise können zum Beispiel die Zusammensetzung, Struktur und Dynamik der zu untersuchenden Substanz aufgeklärt und ebenfalls die Konzentration der zu untersuchenden Substanz bestimmt werden.

Bei der NMR-Messung wird die Substanz einem starken statischen, homogenen Magnetfeld B₀ ausgesetzt, wodurch die Kernspins in der Substanz ausgerichtet werden. In die zu untersuchende Substanz werden dann hochfrequente elektromagnetische Impulse eingestrahlt. Die hierbei erzeugten, ebenfalls hochfrequenten elektromagnetischen Felder werden im NMR-Spektrometer detektiert. Daraus können dann Informationen über die Eigenschaften der untersuchten Substanz gewonnen werden.

Sowohl bei der hochauflösenden Magnetresonanz Spektroskopie wie auch in der bildgebenden Magnetresonanz, sind die Anforderungen an die Magnetfeldhomogenität sehr hoch. Um die Homogenitätsspezifikationen zu erreichen, werden häufig elektrische Kryoshims eingesetzt. Deren Spulen erzeugen elementare Feldprofile. Mit geeigneten Strömen versehen können sie die Homogenität des NMR-Magneten am Probenort verbessern.

Manchmal wird auch kaltes ferromagnetisches Material (beispielsweise Eisen- oder Stahllegierungen) als Shimelement zur Verbesserung der Homogenität verwendet, wie beispielsweise in der Druckschrift DE 10 2015 225 731 B3 (=Referenz [7]) beschrieben wird. Unabhängig davon, wie ein Magnet kalt geshimmt wird, bleibt am Schluss eine Restinhomogenität bestehen, die in der Magnetbohrung außerhalb des Vakuumbehälters korrigiert werden muss. Zu diesem Zweck werden sogenannte Raumtemperaturshims (in der Folge "RT-Shims" genannt) eingesetzt. Diese Raumtemperaturshims können wie die Kryoshims entweder Spulen, ferromagnetisches Material oder eine Kombination der beiden umfassen. Obwohl der Name "Raumtemperaturshims" suggeriert, dass sich diese Shims auf Labortemperatur befinden, ist das nicht zwingend der Fall: Die in den Shimspulen dissipierte Leistung sorgt oft dafür, dass ihre Temperatur gegenüber der Labortemperatur leicht erhöht ist. Zudem werden manchmal auch NMR-Experimente mit Probensubstanzen bei variablen Temperaturen durchgeführt. In der Folge wird der Einfachheit halber trotzdem immer von "RT-Shims" und von "Raumtemperatur" die Rede sein. Die RT-Shims müssen also nicht zwingend bei Raumtemperatur betrieben werden.

Der supraleitende NMR-Magnet ist mechanisch über einen langen Weg mit den RT-Shims verbunden. Ein Teil dieses Weges verläuft im Kaltbereich eines Kryostaten, ein weiterer Teil befindet sich auf Raumtemperatur. Letzterer Teil des Weges folgt den Schwankungen der Umgebungstemperatur und verändert seine Länge aufgrund seiner thermischen Ausdehnung: Es kommt folglich zu einer relativen Bewegung zwischen dem supraleitenden Magneten und den RT-Shims. Die RT-Shims sind dann nicht mehr ideal zur Kompensation der Feldinhomogenität abgestimmt und die Qualität der Magnetresonanzbilder oder -spektren verschlechtert sich.

Umfassen die RT-Shims Spulen oder Spulensysteme, dann können deren Ströme angepasst und so die ursprüngliche Qualität wiederhergestellt werden. Eine ähnliche Verschiebung der RT-Shimströme könnte man beobachten, wenn diese Ströme selber driften würden, z.B. aufgrund von temperaturabhängigen Stromquellen. Im Folgenden wird deshalb manchmal (eher salopp) davon gesprochen, dass die RT-Shimströme mit der Umgebungstemperatur «driften».

Empfindliche Geräte werden zwar oftmals in klimatisierten Räumen betrieben, aber Temperaturschwankungen von 1° C während des Tages sind trotzdem keine Seltenheit. In vielen Anwendungen können die RT-Shimströme automatisch angepasst werden. Ist das nicht möglich, können die Homogenitätsschwankungen während der Messung störend sein.

Vergleichbare Homogenitätsschwankungen treten auf, wenn die Temperatur, z.B. in der Magnetbohrung, aus anderen Gründen zeitlich veränderlich ist. Eine solche Situation kommt z.B. vor, wenn die NMR-Messprobe gewechselt wird und neu geshimmt werden muss. Die von den RT-Shims dissipierte Leistung kann sich von der vorherigen RT-Shimleistung unterscheiden und neue Temperaturverhältnisse in der Magnetbohrung hervorrufen. Es braucht dann eine gewisse Zeit, bis sich die Temperatur auf das neue Niveau einpendelt. In dieser Zeit müssen die Shimströme immer wieder angepasst werden. Ein ähnliches Problem tritt auf, wenn die Temperatur der NMR-Messprobe geändert wird.

Eine naheliegende Lösung des Problems kann in erster Näherung darin bestehen, die Fluktuationen der Umgebungstemperatur möglichst klein zu halten. Je größer das Labor, umso teurer und aufwändiger wird es, eine Klimaanlage mit hinreichender Präzision zu betreiben.

In einem zweiten, verfeinerten Ansatz können die Shimströme automatisch der schwankenden Homogenität angepasst werden. Dies ist allerdings nur dann möglich, wenn eine Lock-Substanz verfügbar ist, was z.B. bei Festkörper-Experimenten nicht der Fall ist.

### Spezieller Stand der Technik:

Ein hochauflösendes NMR-Spektrometer mit einem supraleitenden NMR-Magnetspulensystem, das mit einem Pulsrohrkühler auf kryogene Temperaturen gekühlt wird, und das im Kaltbereich eines Kryostaten innerhalb eines Vakuumbehälters angeordnet ist, wird beschrieben in EP 0 780 698 B1 (= Referenz [2]).

In EP 2 015 092 A1 (= Referenz [3]) wird das Problem der Shimdrift aufgrund von atmosphärischen Druckschwankungen angesprochen. Ähnlich wie bei Temperaturschwankungen kommt es zu einer Relativbewegung zwischen den RT-Shims und dem supraleitenden Magneten. Um die Relativbewegung zu minimieren, wird eine Brücke verwendet, die am äußeren Rand des Kryostaten fixiert wird und somit die Bewegung des zentralen Bereichs des Kryostaten bei Druckschwankungen nicht mitmacht. Das RT-Shimsystem wird an dieser Brücke festgemacht.

Quantitative klinische NMR-Analysegeräte mit einer automatischen Kompensation der Temperatur-Empfindlichkeit über einen großen Temperaturbereich sind in der EP 3 686 620 A1 (= Referenz [4]) beschrieben.

In der Publikation "Acyclic Acids-Advances in Research and Application: 2013 Edition: ScholarlyBrief", Q. Ashton Acton, PhD, ScholarlyEditions, 2013, p139 (= Referenz [5]) wird ebenfalls auf die Temperaturempfindlichkeit der Elektronik in NMR-Analysatoren eingegangen. Eine Temperierung der Elektronik kann demnach Abhilfe schaffen.

Die Publikation "Modern Instrumental Analysis", Satinder Ahuja, Neil Jespersen, Elsevier, 2006, p270 (= Referenz [6]) weist auf die Temperaturempfindlichkeit der Probensubstanz hin. Durch eine Temperaturregulierung am Ort der Substanz kann diesem Effekt entgegengewirkt werden.

Aus der bereits oben zitierten DE 10 2015 225 731 B3 (= Referenz [7]) ist ein Helium-gekühltes supraleitendes Magnetspulensystem in einer NMR-Apparatur mit leicht zugänglicher, ebenfalls tiefgekühlter NMR Shim-Anordnung bekannt. Die NMR-Apparatur weist zwischen einem Helium-Innenrohr und einem Strahlungsschildinnenrohr eine Feldformeinrichtung auf, welche in starrem mechanischen Kontakt mit dem Helium-Behälter steht, ohne dabei das Strahlungsschildinnenrohr zu berühren.

Die ebenfalls bereits oben zitierte Referenz [1] offenbart eine bezüglich der vorliegenden Erfindung generische NMR-Apparatur mit sämtlichen eingangs definierten Merkmalskomplexen einschließlich dem gattungsgemäßen Shimsystem. Allerdings bestehen auch bei dieser Apparatur die oben beschriebenen Probleme hinsichtlich von Schwankungen der Magnetfeld-Homogenität aufgrund von Temperaturveränderungen in einem auch in Laboren üblichen Rahmen.

### Aufgabe der Erfindung

Der vorliegenden Erfindung liegt demgegenüber die Aufgabe zugrunde, eine NMR-Apparatur mit den eingangs definierten Merkmalen mit Hilfe besonders einfacher, leicht zugänglicher technischer Mittel sowie möglichst kostengünstig so zu modifizieren, dass die Magnetfeldhomogenität auch bei sich verändernden Temperaturverhältnissen innerhalb und im Umfeld der Apparatur weitestgehend stabil und konstant gehalten wird.

### Kurze Beschreibung der Erfindung

Diese Aufgabe wird durch die vorliegende Erfindung auf ebenso überraschend einfache wie wirkungsvolle Weise dadurch gelöst, dass auf mindestens einem Abschnitt eines Pfades entlang des Vakuumbehälters von einer ersten mechanischen Verbindungsstelle zwischen Magnetaufhängung und Vakuumbehälter bis zu einer zweiten mechanischen Verbindungsstelle zwischen Positionierungselement für das Shimsystem und Vakuumbehälter und/oder auf mindestens einem Abschnitt eines Pfades entlang des Positionierungselementes von der zweiten mechanischen Verbindungsstelle zum Shimsystem nur Materialien eingesetzt sind, deren Wärmeausdehnungskoeffizient bei Betriebstemperatur kleiner ist als 5 ppm/K.

Die vorliegende Erfindung schlägt also vor, mittels der vorgeschriebenen Materialauswahl auf den Pfaden eine stabile Magnetfeld-Homogenität zu erreichen.

Durch diese erfindungsgemäße Ausgestaltung der Pfade, insbesondere durch den geringen Wärmeausdehnungskoeffizienten der gewählten Materialien, wird die Dehnungsänderung des entsprechenden Pfadabschnitts bei einer Temperaturschwankung minimiert, so dass die Relativbewegung zwischen supraleitendem Magneten und Shimsystem klein gehalten wird. Dadurch bleibt die Feldhomogenität stabil.

Herkömmliche metallische Materialien wie Stahl oder Aluminium haben bei Raumtemperatur einen thermischen Ausdehnungskoeffizienten von etwa 20 ppm/K. Zur Reduzierung der Relativbewegungen zwischen Shimsystem und supraleitendem Magneten bei Schwankungen der Raumtemperatur können auf dem Verbindungsweg dieser beiden Komponenten Materialien mit viel kleinerer thermischer Ausdehnung verwendet werden.

Kohlenstoffverstärkter Kunststoff (CFK) hat entlang seiner Fasern einen Wärmeausdehnungskoeffizienten von weniger als 1 ppm/K. Dieses Material kann z.B. in der Magnetbohrung in Teilen des Positionierungselements für das Shimsystem verwendet werden.

Bei der Stahlsorte Invar beträgt der Wärmeausdehnungskoeffizient weniger als 2 ppm/K. Dieser Stahl kann in Teilen des Vakuumbehälters eingesetzt werden. CFK hingegen ist als Material für den Vakuumbehälter ungeeignet, da es nicht geschweißt werden kann.

Relativbewegungen können auch reduziert werden, indem auf einem Abschnitt des Verbindungswegs zwischen supraleitendem Magneten und Shimsystem die Temperatur durch einen Regelkreis konstant gehalten wird. Die Temperatur oder die Dehnung wird an verschiedenen Orten gemessen und es wird bei Bedarf geheizt. Die Bereiche mit Heizern werden künstlich wärmer gehalten als die Umgebungstemperatur. Alternativ dazu kann auch mit TEC-Elementen (Thermolelectric Coolers) gekühlt werden. Die Bereiche mit TEC-Elementen werden dann künstlich kälter gehalten als die Umgebungstemperatur.

Die Temperatur kann auch in der Bohrung des Magneten mit einem temperierten Gas konstant gehalten werden.

### Bevorzugte Ausführungsformen und Weiterbildungen der Erfindung

Bei ganz besonders bevorzugten Ausführungsformen der erfindungsgemäßen NMR-Apparatur ist vorgesehen, dass die Länge des Pfad-Abschnittes entlang des Vakuumbehälters von der ersten mechanischen Verbindungsstelle zur zweiten mechanischen Verbindungsstelle und/oder die Länge des Pfad-Abschnittes entlang des Positionierungselementes von der zweiten mechanischen Verbindungsstelle zum Shimsystem jeweils mehr als 50% der Gesamtlänge des entsprechenden Pfades beträgt.

Shimspulen sind üblicherweise auf einem Aluminiumträger gewickelt. Aluminium hat durch seine gute Wärmeleitfähigkeit den Vorteil, dass die in den Spulen dissipierte Wärme gut wegtransportiert wird. Aluminium hat aber leider einen großen Wärmeausdehnungskoeffizienten von ca. 23 ppm/K. Bei der Umsetzung der Erfindung wird nur das Verbindungsstück vom Aluminiumträger der Shimspulen zur zweiten mechanischen Verbindungsstelle aus einem Material mit kleinem Wärmeausdehnungskoeffizienten gefertigt. Sind die Shimelemente keine Spulen, sondern Plättchen aus ferromagnetischem Material, kann sogar das gesamte Positionierungselement aus einem Material mit kleinem Wärmeausdehnungskoeffizienten gefertigt werden. Außerhalb der Magnetbohrung werden die Kalotte des Vakuumbehälters und dessen Verbindungsflansch zum Innenrohr auch nicht notwendigerweise aus einem Material mit kleinem Wärmeausdehnungskoeffizienten gefertigt. Mit diesem Hintergrund können aber problemlos für mehr als 50% der Gesamtlänge der Pfade Materialien mit kleinem Wärmeausdehnungskoeffizienten verwendet werden.

Besonders vorteilhaft sind auch Ausführungsformen der erfindungsgemäßen NMR-Apparatur, bei denen auf dem Pfad entlang des Vakuumbehälters von der ersten mechanischen Verbindungsstelle zur zweiten mechanischen Verbindungsstelle und/oder auf dem Pfad entlang des Positionierungselementes von der zweiten mechanischen Verbindungsstelle zum Shimsystem abschnittsweise Materialien mit unterschiedlichen Wärmeausdehnungskoeffizienten eingesetzt sind, deren Wärmeausdehnungen sich jeweils gegenseitig kompensieren.

Damit bleiben dann nur noch deutlich geringere absolute Wärmeausdehnungen übrig, die im Rahmen einer Feinjustage mit Hilfe der Erfindung schließlich auch noch minimiert werden können.

Ebenfalls bevorzugt sind Ausführungsformen, bei denen als Material auf dem mindestens einen Abschnitt des Pfades entlang des Vakuumbehälters von der ersten mechanischen Verbindungsstelle zur zweiten mechanischen Verbindungsstelle Invar eingesetzt ist.

Vorteilhaft ist dabei eine Reduzierung der Relativbewegungen zwischen supraleitendem Magneten und Shimsystem. Invar hat typischerweise einen Wärmeausdehnungskoeffizienten von weniger als 2 ppm/K. Invar hat zudem den Vorteil, dass es schweißbar ist. Der Vakuumbehälter muss vakuumdicht sein, was hohe Anforderungen an alle mechanischen Verbindungsstellen stellt. Die Teilstrecke, von der hier die Rede ist, würde sich bei gängigen Kryostaten mit vertikaler Magnetbohrung über einen oder mehrere Aufhängetürme erstrecken.

Invar wird allerdings durch das Hintergrundfeld des supraleitenden Magneten magnetisiert. Da sich Invar nur im kleinen Streufeldbereich des supraleitenden Magneten befindet, sind zumindest bei aktiv abgeschirmten Magneten keine Nachteile zu erwarten. Die Kräfte und das Störfeld der Magnetisierung sind jedenfalls klein.

Alternativ oder ergänzend ist bei weiteren Ausführungsformen der Erfindung als Material auf dem mindestens einen Abschnitt des Pfades entlang des Positionierungselementes von der zweiten mechanischen Verbindungsstelle zum Shimsystem CFK (= Carbonfaser-verstärkter Kunststoff) eingesetzt. Typischerweise hat CFK entlang seiner Fasern einen Wärmeausdehnungskoeffizienten von weniger als 1 ppm/K. Durch den geringen Wärmeausdehnungskoeffizienten wird die Dehnungsänderung bei einer Temperaturschwankung minimiert, so dass die Relativbewegung zwischen supraleitendem Magneten und Shimsystem klein gehalten wird. Dadurch bleibt die Feldhomogenität stabil.

Bei bevorzugten Weiterbildungen dieser Ausführungsformen ist der Abstand von der ersten mechanischen Verbindungsstelle zur zweiten mechanischen Verbindungsstelle kleiner als 10 cm.

Vorteilhafterweise ist die thermische Ausdehnung von CFK oder von ähnlichen Materialien kleiner als die thermische Ausdehnung aller Metalle, inklusive Invar. Deshalb ist es zielführend, solche Materialien auf einem möglichst großen Anteil der Verbindungslänge zwischen Shimsystem und der ersten mechanischen Verbindungsstelle zu verwenden. In der Praxis kann das Positionierungselement für das Shimsystem mit einem Gerüst aus CFK an den Aufhängetürmen fixiert werden.

Vorteilhaft sind auch Ausführungsformen der Erfindung, bei welchen auf mindestens einem Abschnitt eines weiteren Pfades entlang des Positionierungselementes von der zweiten mechanischen Verbindungsstelle zum Shimsystem Materialien eingesetzt sind, deren Wärmeleitfähigkeit bei Betriebstemperatur größer ist als 50 W/(mK), insbesondere Kupfer.

Wenn hohe Ströme in den Shimelementen erforderlich sind, besteht nämlich die Gefahr einer Überhitzung. Diesem Problem kann entgegengewirkt werden, indem im Positionierungselement thermisch gut leitendes Material, beispielsweise gleitende Kupferschienen, eingelegt wird, welches aber mechanisch nicht oder nur wenig zur Wärmeausdehnung des Positionierungselements beiträgt. Es kann auch parallel zum Positionierungselement ein gleitendes Rohr aus Aluminium oder Kupfer eingesetzt werden. Auch die Verwendung von Flushgas trägt zur Abführung der Wärme bei.

Weitere vorteilhafte Ausführungsformen der erfindungsgemäßen NMR-Apparatur zeichnen sich dadurch aus, dass die Shimelemente als elektrische Spulen und/oder als ferromagnetische Elemente ausgebildet sind.

Ferromagnetische Elemente haben den Vorteil, dass sie zur Feldhomogenisierung beitragen, ohne Wärme zu dissipieren. Sie werden üblicherweise in Geräten für die Magnetresonanztomographie eingesetzt. Elektrische Shimspulen zeichnen sich dadurch aus, dass ihr Strom variabel ist und dass sie deshalb dynamisch auf Homogenitätsschwankungen reagieren können. In der hochauflösenden Kernspinresonanz sind Shimspulen unabdingbar. Sie können aber mit ferromagnetischen Elementen kombiniert werden.

Ebenfalls bevorzugt sind Ausführungsformen der Erfindung, bei denen der Vakuumbehälter eine vertikale Raumtemperatur-Bohrung aufweist, in welcher das Shimsystem angeordnet ist, und bei denen das Positionierungselement einen Klemmring umfasst, wobei die Auflagefläche des Klemmrings auf dem oberen Ende der Raumtemperatur-Bohrung des Vakuumbehälters die zweite mechanische Verbindungsstelle bildet.

Die mechanische Verbindungslänge zwischen der ersten mechanischen Verbindungsstelle, welche bei einem vertikalen Kryostaten im oberen Bereich des Vakuumbehälters liegt, und der zweiten mechanischen Verbindungsstelle wird dadurch minimiert, dass die zweite mechanische Verbindungsstelle ebenfalls im oberen Bereich des Vakuumbehälters liegt. Eine kleine Länge verändert sich bei Temperaturschwankungen weniger stark als eine große Länge.

Eine bevorzugte Klasse von Ausführungsformen der erfindungsgemäßen NMR-Apparatur ist dadurch gekennzeichnet, dass auf einem Abschnitt des Pfades entlang des Vakuumbehälters von der ersten mechanischen Verbindungsstelle zur zweiten mechanischen Verbindungsstelle und/oder auf einem Abschnitt des Pfades entlang des Positionierungselementes von der zweiten mechanischen Verbindungsstelle zum Shimsystem ein Regulierungselement zur Regulierung thermisch bedingter Längenänderungen auf dem betreffenden Pfad angeordnet ist, das vorzugsweise ein Heizelement und/oder ein Kühlelement und/oder einen Wärmetauscher umfasst.

Mit dem Regulierungselement kann die Temperaturschwankung auf dem Abschnitt klein gehalten werden. Dadurch wird die Relativbewegung zwischen dem supraleitenden Magneten und dem Shimsystem minimiert und die Feldhomogenität bleibt stabil.

Bei bevorzugten Weiterbildungen dieser Klasse von Ausführungsformen ist zusätzlich zum Regulierungselement auf dem betreffenden Pfad auch ein Sensorelement angeordnet, welches vorzugsweise ein Thermometer, insbesondere einen PT-100 Sensor, und/oder ein Dehnungsmesselement umfasst.

Als thermisches Sensorelement sind Platin-Widerstandsthermometer (typischerweise PT-100) besonders geeignet, weil sie im Bereich der Raumtemperatur genaue Temperaturmessungen ermöglichen.

Vorteilhaft ist dabei eine Reduzierungsmöglichkeit der Relativbewegungen zwischen dem supraleitendem Magneten und dem Shimsystem durch eine Dehnungskontrolle. Der Abschnitt eines Pfades entlang des Vakuumbehälters, von dem hier die Rede ist, könnte bei gängigen Kryostaten ein Aufhängeturm bzw. alle Aufhängetürme umfassen. Das Sensorelement liefert die Größe, die konstant gehalten werden muss, was durch die Regelung des Stroms im Heizelement bzw. im Kühlelement gewährleistet wird.

Bevorzugt sind auch Weiterentwicklungen dieser Weiterbildungen, die sich dadurch auszeichnen, dass das Sensorelement einen Laser umfasst, mit welchem mittels einer elektro-optischen Distanzmessung, insbesondere interferometrisch, eine Positionsänderung eines beobachteten Pfad-Abschnitts detektiert werden kann.

Ähnlich wie beim Thermometer und/oder beim Dehnungsmesselement wird mit dem Laser eine Längenänderung festgestellt, die mit dem Strom im Heizelement bzw. im Kühlelement reguliert werden kann. Der Laser kann zum Beispiel die Längenänderung des Positionierungselements oder eines Aufhängeturms überwachen.

Ebenfalls bevorzugt kann bei diesen Weiterentwicklungen vorgesehen sein, dass mindestens ein Piezoelement vorhanden ist, mittels dessen eine beobachtete Dehnungsänderung eines Pfad-Abschnitts korrigiert wird.

Das Piezoelement kann zum Beispiel im Positionierungselement eingebaut sein. Durch Anlegen einer elektrischen Spannung kann seine Länge so angepasst werden, dass die Gesamtlänge des Positionierungselements zeitlich konstant bleibt.

Bei einer weiteren, besonders bevorzugten Klasse von Ausführungsformen der erfindungsgemäßen NMR-Apparatur ist der supraleitende Magnet in einem im Betrieb mit flüssigem Helium gefüllten Heliumbehälter des Kryostaten innerhalb des Vakuumbehälters angeordnet, wobei der Heliumbehälter vorzugsweise von einem mit flüssigem Stickstoff gefüllten Stickstoffbehälter des Kryostaten radial umgeben ist.

Die meisten Kryostaten werden in der Praxis auf diese Art betrieben. Die erste mechanische Verbindungsstelle umfasst bei Vertikalmagneten eine oder mehrere Schweißnähte, die die Magnetaufhängung, in diesem Fall die Helium-Aufhängerohre, mit dem Vakuumbehälter verbinden.

Ebenfalls von Vorteil können Ausführungsformen sein, bei denen der Kryostat einen Kryokühler umfasst, mittels dessen der supraleitende Magnet auf seine Betriebstemperatur gekühlt werden kann.

Hier ist vorteilhafterweise kein Nachfüllen von Helium notwendig. Bei Helium-Knappheit hat man deshalb dann keine Probleme.

Vorteilhaft können prinzipiell auch Ausführungsformen der erfindungsgemäßen NMR-Apparatur sein, bei denen der Vakuumbehälter vollständig von einer temperierten Box umgeben, vorzugsweise in einem klimatisierten Raum aufgebaut ist. Ein klimatisierter Raum ist im Prinzip schon eine solche Box. Wie Beispiele aus der Praxis zeigen, kann aber eine zusätzliche Isolations-Box die Temperierung noch deutlich verbessern.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische vertikale Schnittansicht auf eine Ausführungsform der erfindungsgemäßen NMR-Apparatur, in welcher das Positionierungselement einen Klemmring umfasst, wobei die Auflagefläche des Klemmrings auf dem oberen Ende der Raumtemperatur-Bohrung des Vakuumbehälters die zweite mechanische Verbindungsstelle bildet;
- Fig. 2: einen schematischen Vertikalschnitt durch eine Ausführungsform der erfindungsgemäßen NMR-Apparatur ähnlich wie in Fig. 1, jedoch mit einem im Pfad entlang des Positionierungselementes von der zweiten mechanischen Verbindungsstelle zum Shimsystem angeordneten mechanischen Aktuator;
- Fig. 3: eine weitere Ausführungsform der erfindungsgemäßen NMR-Apparatur, in welcher das Positionierungselement ein Gerüst umfasst, wobei die Auflagefläche des Gerüsts auf dem oberen Ende des Aufhängeturms der Magnetaufhängung die zweite mechanische Verbindungsstelle bildet;
- Fig. 4: einen Ausschnitt der erfindungsgemäßen NMR-Apparatur mit dem Verschaltungsschema für mehrere Regulierungs- und Sensorelemente;
- Fig. 5: einen Ausschnitt der erfindungsgemäßen NMR-Apparatur mit dem Verschaltungsschema für mehrere Regulierungs- und Sensorelemente mit nur einem einzigen Regelkreis; und
- Fig. 6: eine schematische vertikale Schnittansicht auf eine Ausführungsform der erfindungsgemäßen NMR-Apparatur mit einem temperierten Fluid, welches die Aufhängetürme und das Positionierungselement auf einer konstanten Temperatur hält.

Generell befasst sich die vorliegende Erfindung mit einer modifizierten NMR-Apparatur mit einem Magnetspulensystem zur Erzeugung eines homogenen Magnetfelds, welches einen **supraleitenden Magneten 1** umfasst, der im Kaltbereich eines Kryostaten innerhalb eines **Vakuumbehälters 8** angeordnet ist. Außerdem umfasst die NMR-Apparatur ein **Shimsystem 7,** das außerhalb des Vakuumbehälters 8 angeordnete **Shimelemente 6** enthält, welche als elektrische Spulen und/oder als ferromagnetische Elemente ausgebildet sein können. Der supraleitende Magnet 1 weist zudem über eine **Magnetaufhängung 3** eine **erste mechanische Verbindungsstelle 11** mit dem Vakuumbehälter 8 auf, wobei die Magnetaufhängung 3 ihrerseits in einem **Aufhängeturm 4** angeordnet ist. Das Shimsystem 7 weist über ein **Positionierungselement 5** mit dem Vakuumbehälter 8 eine **zweite mechanische Verbindungsstelle 10; 12** auf.

Das Shimsystem 7 umfasst neben den Shimelementen 6 typischerweise auch eine Halterungsstruktur der Shimelemente 6, so dass das Shimsystem 7 nicht nur funktional, sondern auch strukturell eine Einheit bildet. Die Halterungsstruktur erlaubt es, die Gesamtheit der Shimelemente 6 mit einem Positionierungselement 5 mechanisch zu verbinden, oder sie dient als Führung elektrischer Leitungen zu den Shimelementen 6 oder als mechanische Schnittstelle zu einem NMR-Probenkopf. Die begriffliche Unterscheidung zwischen Positionierungselement 5 und anderen strukturellen Komponenten, beispielsweise einer Halterungsstruktur der Shimelemente 6, sei dadurch gegeben, dass alle strukturellen Komponenten in einem Pfad zwischen einer zweiten mechanische Verbindungsstelle 10; 12 zum Vakuumbehälter 8 auf der einen Seite und mindestens einem Shimelement 6 auf der anderen Seite als Positionierungselemente 5 aufzufassen sind, wenn ihre Dehnung die Position oder Ausrichtung dieses Shimelementes 6 relativ zum supraleitenden Magneten 1 beeinflusst.

Der supraleitende Magnet 1 ist normalerweise in einem im Betrieb mit flüssigem Helium gefüllten **Heliumbehälter 2** des Kryostaten innerhalb des Vakuumbehälters 8 angeordnet, wobei der Heliumbehälter 2 vorzugsweise von einem mit flüssigem Stickstoff gefüllten **Stickstoffbehälter 9** des Kryostaten radial umgeben ist. Der Kryostat kann auch einen Kryokühler umfassen, mittels dessen der supraleitende Magnet 1 auf seine Betriebstemperatur gekühlt werden kann.

Die vorliegende Erfindung ist demgegenüber dadurch charakterisiert, dass auf mindestens einem Abschnitt eines Pfades entlang des Vakuumbehälters 8 von der ersten mechanischen Verbindungsstelle 11 zur zweiten mechanischen Verbindungsstelle 10; 12 und/oder auf mindestens einem Abschnitt eines Pfades entlang des Positionierungselementes 5 von der zweiten mechanischen Verbindungsstelle 10; 12 zum Shimsystem 7 nur Materialien eingesetzt sind, deren Wärmeausdehnungskoeffizient bei Betriebstemperatur kleiner ist als 5 ppm/K.

Günstig kann es auch sein, wenn auf dem Pfad entlang des Vakuumbehälters 8 von der ersten mechanischen Verbindungsstelle 11 zur zweiten mechanischen Verbindungsstelle 10; 12 und/oder auf dem Pfad entlang des Positionierungselementes 5 von der zweiten mechanischen Verbindungsstelle 10; 12 zum Shimsystem 7 abschnittsweise Materialien mit unterschiedlichen Wärmeausdehnungskoeffizienten eingesetzt sind, deren Wärmeausdehnungen sich jeweils gegenseitig kompensieren.

Vorzugsweise beträgt die Länge des Pfad-Abschnittes entlang des Vakuumbehälters 8 von der ersten mechanischen Verbindungsstelle 11 zur zweiten mechanischen Verbindungsstelle 10; 12 und/oder die Länge des Pfad-Abschnittes entlang des Positionierungselementes 5 von der zweiten mechanischen Verbindungsstelle 10; 12 zum Shimsystem 7 jeweils mehr als 50% der Gesamtlänge des entsprechenden Pfades.

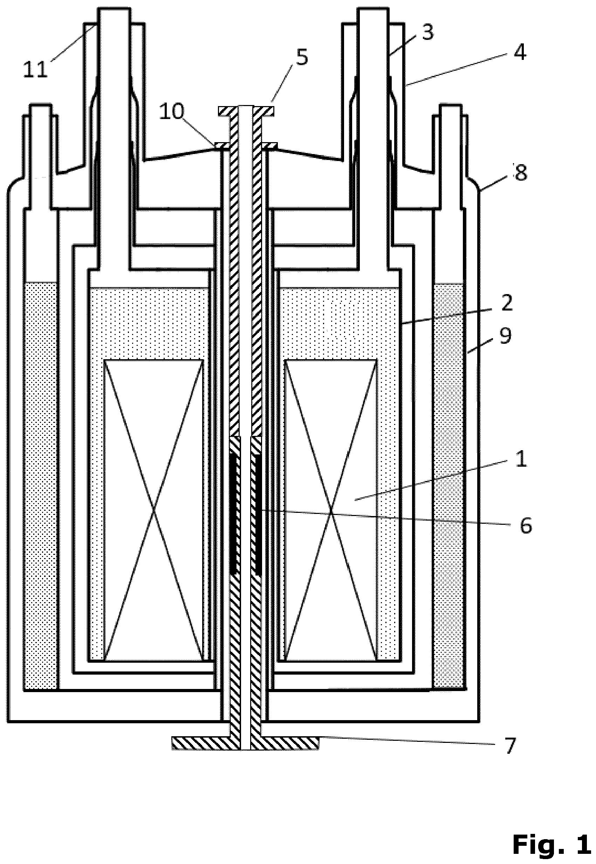

In **Fig. 1** ist eine besonders vorteilhafte zweiteilige mechanische Struktur zur Anordnung von Shimelementen 6 in einer Magnetbohrung gezeigt. Der obere Teil der mechanischen Struktur stellt den Verbindungspfad vom Shimsystem 7 zur zweiten mechanischen Verbindungsstelle 10 zwischen Klemmring und Vakuumbehälter 8 her und dient definitionsgemäß als Positionierungselement 5. Der untere Teil der mechanischen Struktur wird dem Shimsystem 7 zugerechnet und dient zur Halterung der Gesamtheit der Shimelemente 6, zur Einführung der Shimelemente 6 von unten in die Magnetbohrung, zur Aufnahme eines NMR-Probenkopfs und zur Führung elektrischer Zuleitungen zu den Shimelementen 6. Die zweiteilige Ausführung der mechanischen Struktur zur Anordnung der Shimelemente 6 vereinfacht den Einbau in die Magnetbohrung. Im Betriebszustand sind die beiden Strukturen beispielsweise durch Schrauben mechanisch verbunden. Demgegenüber sind auch einteilige Strukturen denkbar, bei welchen das Shimsystem 7 als Gesamtheit aller Shimelemente 6 keine strukturellen Komponenten aufweist und das Positionierungselement 5 auch als Halterung der Shimelemente 6 dient und weitere der oben genannten Funktionen übernehmen kann.

Das Positionierungselement 5 in Fig. 1 umfasst einen Klemmring, dessen Auflagefläche auf dem oberen Ende der Raumtemperatur-Bohrung des Vakuumbehälters 8 die zweite mechanische Verbindungsstelle 10 bildet.

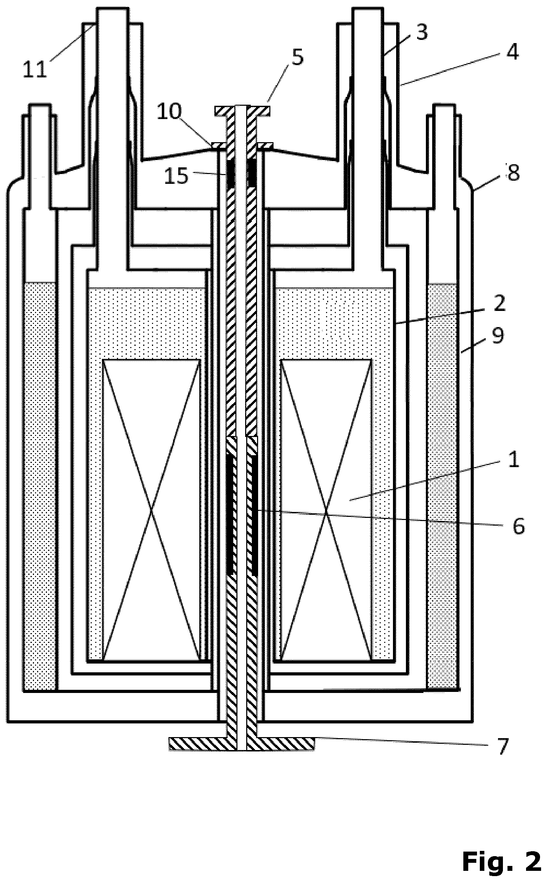

**Fig. 2** zeigt eine Ausführungsform der NMR-Apparatur wie in Fig. 1, jedoch zusätzlich mit einem **mechanischen Aktuator 15,** der unterhalb des Klemmrings 10 angeordnet ist.

Wie in Fig. 2 anschaulich dargestellt, kann das Piezoelement 15 in das Positionierungselement 5 eingebaut sein. Soll die Position des Shimsystems 7 verändert werden, kann das Piezoelement 15 mit einer entsprechenden elektrischen Spannung gespeist werden. Die Längenänderung des Piezokristalls ist dann proportional zur angelegten Spannung und es sind auch negative Spannungen möglich. Mit der Dicke eines Piezostapels in Sandwichbauweise kann der Bereich der möglichen Verschiebung den Verschiebungsanforderungen angepasst werden.

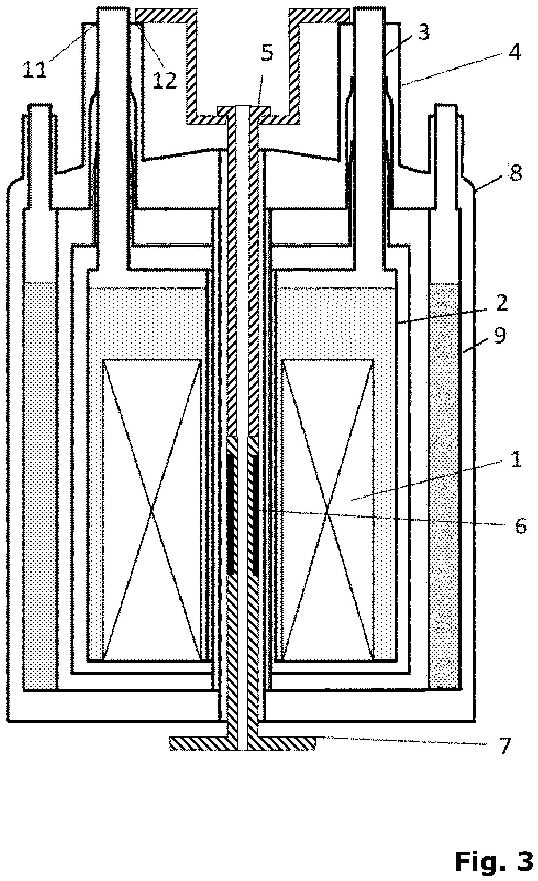

In **Fig. 3** hängt hingegen das Positionierungselement für das Shimsystem 7 über ein Gerüst an den Aufhängetürmen. Auf diese Weise fallen die erste und die zweite mechanische Verbindungsstelle fast zusammen und der Pfad entlang des Vakuumbehälters, der die beiden mechanischen Verbindungsstellen miteinander verbindet, wird minimiert. Insbesondere können die Verbindungselemente 12 aus einem Material mit kleinem Wärmeausdehnungskoeffizienten hergestellt werden, so dass sich keine wesentlichen Dehnungen bei Temperaturschwankungen ergeben.

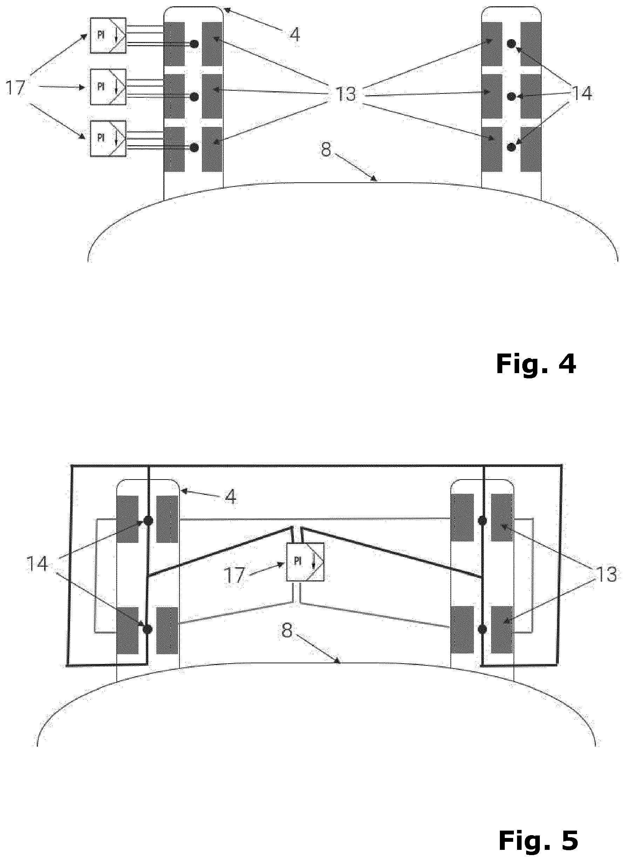

**Fig. 4** stellt in einem Ausschnitt eines schematischen Vertikalschnitts durch die erfindungsgemäße NMR-Apparatur mit mehreren **Regulierungselementen 13** und **Sensorelementen 14** ein Beispiel von Reglern auf den Aufhängetürmen 4 (hier: pro Turm drei Regelgrößen und drei Regulierungselemente) vor. Dies veranschaulicht, wie mit mehreren Regelkreisen die Dehnungsänderungen abschnittsweise auf den verschiedenen Aufhängetürmen 4 klein gehalten werden können. Mit einer solchen Lösung wird die maximale Kontrolle über die Dehnung gewonnen. Der Aufwand dafür ist freilich relativ groß, weil man mehrere Stromquellen und mehrere Regler braucht.

Das spezielle Ausführungsbeispiel von Fig. 4 zeigt als Heizelemente ausgebildete Regulierungselemente 13 und Sensorelemente 14 auf den Aufhängetürmen 4. Mit Hilfe der Sensorelemente 14 wird die Dehnung oder die Temperatur der Aufhängetürme 4 gemessen und mit den Heizern kann der gemessenen Dehnungsänderung entgegengewirkt werden.

Schematisch dargestellt sind in Fig. 4 auch **elektronische Regelungseinheiten 17** (hier in Form von PI-Reglern), die den Strom der Heizelemente als Funktion der gemessenen Dehnung regeln. PI-Regler sind freilich nur ein Beispiel aus einer großen Vielfalt möglicher Regler, die aus der Regelungstechnik an sich bekannt sind. In der Regelungstechnik gibt es noch viele andere Regler, auf die hier aber nicht im Detail eingegangen werden soll. Als Sensorelemente 14 können beispielsweise PT-100-Temperatursensoren verwendet werden.

Für eine Temperaturmessung sind PT-100 Sensoren eine gute Wahl, da sie im Raumtemperaturbereich besonders empfindlich sind. Alternativ dazu können andere Temperatursensoren oder Dehnungsmesselemente verwendet werden. Heizelemente umfassen meistens einen mäanderförmigen Draht, der möglichst viel Fläche abdeckt.

Des Weiteren ist in Fig. 4 die Stromspeisung der jeweiligen Sensorelemente 14 schematisch angedeutet.

Die Aufhängetürme 4 samt Sensorelementen 14 und Regulierungselementen 13 werden üblicherweise mit Isolationsmaterial abgedeckt (was in der Figur allerdings nicht eigens dargestellt ist), um Schwankungen der Umgebungstemperatur zu dämpfen. Die Temperatur der Aufhängetürme 4 wird in diesem Beispiel durch die Heizer künstlich etwas höher gehalten als die Umgebungstemperatur, damit auf Erhöhungen der Umgebungstemperatur reagiert werden kann. Statt der Heizelemente können auch Kühlelemente, insbesondere sogenannte thermoelektrische Kühler (= TEC), verwendet werden. In diesem Fall wird die Temperatur der Aufhängetürme 4 sinnvollerweise tiefer gehalten als die Umgebungstemperatur.

Während in Fig. 4 ein Beispiel mit einer Vielzahl von PI-Reglern gezeigt wird, ist es auch möglich, deren Anzahl zu reduzieren, indem mehrere Heiz- oder Kühlelemente in Serie geschaltet werden. Auch die PT-100 Sensoren können schalttechnisch in Serie, in parallel oder in einer Kombination davon geschaltet werden, so dass für die Reglung lediglich eine mittlere Temperatur verwendet wird. Das reduziert oft ohne große Nachteile die Komplexität und den Preis der benötigten Elektronik.

Ein solches Ausführungsbeispiel ist in **Fig. 5** dargestellt. Die Kontrolle über die Dehnung der Aufhängetürme 4 ist allerdings etwas weniger präzise als beim Ausführungsbeispiel nach Fig. 4. Wenn jedoch für die Aufhängetürme 4 ein Material mit guter Wärmeleitfähigkeit verwendet wird, kann der Temperaturgradient über die Aufhängetürme 4 reduziert werden. Kombiniert mit einer guten Isolation der Aufhängetürme 4 gegenüber der Umgebungstemperatur kann die Dehnungsregelung weiter verbessert werden.

Je nach Anwendungsfall gibt es eine Fülle von Möglichkeiten, die sich zwischen den beiden hier vorgestellten Lösungen bewegen können. Ähnliche Anordnungen wie für die Aufhängetürme 4 sind auch für das Positionierungselement 5 möglich.

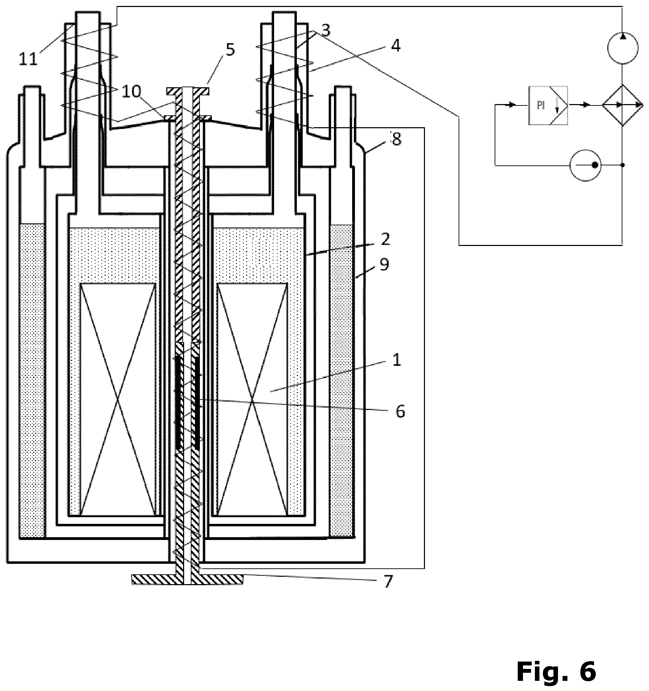

In der **Fig. 6** wird eine Ausführungsform mit einem Flüssigkeitskreislauf gezeigt, welcher entlang der Aufhängetürme 4 und des Positionierungselementes 5 geführt wird. Vorteilhaft an dieser Ausführungsform ist, dass zur Temperaturstabilisierung mehrerer Komponenten nur ein einziges geregeltes Heiz- oder Kühlelement notwendig ist. Eine Temperierflüssigkeit kann große Wärmemengen transportieren, so dass die Temperaturgradienten innerhalb der temperierten Objekte klein gehalten werden können. Dies verbessert die Präzision der Kontrolle thermischer Ausdehnung. Mit einer Isolation zum Außenraum kann der Temperaturgradient innerhalb der temperierten Objekte weiter reduziert werden. Als Temperierfluid kann auch ein Gas verwendet werden. Der Vorteil eines Gases liegt darin, dass es innerhalb der Magnetbohrung offen entlang des Positionierungselementes 5 geführt werden kann.

### Bezugszeichenliste:

- 1: Supraleitender Magnet
- 2: Heliumbehälter
- 3: Magnetaufhängung
- 4: Aufhängeturm
- 5: Positionierungselement für das Shimsystem
- 6: Shimelemente
- 7: Shimsystem
- 8: Vakuumbehälter
- 9: Stickstoffbehälter
- 10: Zweite mechanische Verbindungsstelle
- 11: Erste mechanische Verbindungsstelle
- 12: Alternative zweite mechanische Verbindungsstelle
- 13: Regulierungselement
- 14: Sensorelement
- 15: Mechanischer Aktuator
- 17: elektronische Regelungseinheit

### Referenzliste

Für die Beurteilung der Patentfähigkeit in Betracht gezogene Publikationen:
[1] DE 101 04 365 C1 ≈ GB 2 411 238 B ≈ US 2005/0174118 A1
[2] EP 0 780 698 B1 ≈ US 5,744,959 A
[3] EP 2 015 092 A1
[4] EP 3 686 620 A1
[5] "Acyclic Acids-Advances in Research and Application: 2013 Edition: ScholarlyBrief", Q. Ashton Acton, PhD, ScholarlyEditions, 2013, p139
[6] "Modern Instrumental Analysis", Satinder Ahuja, Neil Jespersen, Elsevier, 2006, p270
[7] DE 10 2015 225 731 B3 ≈ EP 3 182 147 B ≈ US 9,766,312 B1 ≈
   ≈ CN 106898452 B ≈ JP 6340403 B

## Patentansprüche

1. NMR-Apparatur mit einem Magnetspulensystem zur Erzeugung eines homogenen Magnetfelds, welches einen supraleitenden Magneten (1) umfasst, der im Kaltbereich eines Kryostaten innerhalb eines Vakuumbehälters (8) angeordnet ist, und welches ein Shimsystem (7) umfasst, das außerhalb des Vakuumbehälters (8) angeordnete Shimelemente (6) enthält,
wobei der supraleitende Magnet (1) über eine Magnetaufhängung (3) eine erste mechanische Verbindungsstelle (11) mit dem Vakuumbehälter (8) aufweist, und wobei das Shimsystem (7) über ein Positionierungselement (5) mit dem Vakuumbehälter (8) eine zweite mechanische Verbindungsstelle (10; 12) aufweist,
**dadurch gekennzeichnet,**
**dass** auf mindestens einem Abschnitt eines Pfades entlang des Vakuumbehälters (8) von der ersten mechanischen Verbindungsstelle (11) zur zweiten mechanischen Verbindungsstelle (10; 12) und/oder auf mindestens einem Abschnitt eines Pfades entlang des Positionierungselementes (5) von der zweiten mechanischen Verbindungsstelle (10; 12) zum Shimsystem (7) nur Materialien eingesetzt sind, deren Wärmeausdehnungskoeffizient bei Betriebstemperatur kleiner ist als 5 ppm/K.

2. NMR-Apparatur nach Anspruch 1, **dadurch gekennzeichnet, dass** die Länge des Pfadabschnittes entlang des Vakuumbehälters (8) von der ersten mechanischen Verbindungsstelle (11) zur zweiten mechanischen Verbindungsstelle (10; 12) und/oder die Länge des Pfad-Abschnittes entlang des Positionierungselementes (5) von der zweiten mechanischen Verbindungsstelle (10; 12) zum Shimsystem (7) jeweils mehr als 50% der Gesamtlänge des entsprechenden Pfades beträgt.

3. NMR-Apparatur nach Anspruch 1 oder 2, **dadurch gekennzeichnet, dass** auf dem Pfad entlang des Vakuumbehälters (8) von der ersten mechanischen Verbindungsstelle (11) zur zweiten mechanischen Verbindungsstelle (10; 12) und/oder auf dem Pfad entlang des Positionierungselementes (5) von der zweiten mechanischen Verbindungsstelle (10; 12) zum Shimsystem (7) abschnittsweise Materialien mit unterschiedlichen Wärmeausdehnungskoeffizienten eingesetzt sind, deren Wärmeausdehnungen sich jeweils gegenseitig kompensieren.

4. NMR-Apparatur nach einem der vorhergehenden Ansprüche, **dadurch gekennzeichnet, dass** als Material auf dem mindestens einen Abschnitt des Pfades entlang des Vakuumbehälters (8) von der ersten mechanischen Verbindungsstelle (11) zur zweiten mechanischen Verbindungsstelle (10; 12) Invar eingesetzt ist.

5. NMR-Apparatur nach einem der vorhergehenden Ansprüche, **dadurch gekennzeichnet, dass** als Material auf dem mindestens einen Abschnitt des Pfades entlang des Positionierungselementes (5) von der zweiten mechanischen Verbindungsstelle (10; 12) zum Shimsystem (7) CFK (= Carbonfaser-verstärkter Kunststoff) eingesetzt ist.

6. NMR-Apparatur nach einem der vorhergehenden Ansprüche, vorzugsweise nach Anspruch 5, **dadurch gekennzeichnet, dass** der Abstand von der ersten mechanischen Verbindungsstelle (11) zur zweiten mechanischen Verbindungsstelle (10; 12) kleiner ist als 10 cm.

7. NMR-Apparatur nach einem der vorhergehenden Ansprüche, **dadurch gekennzeichnet, dass** auf mindestens einem Abschnitt eines weiteren Pfades entlang des Positionierungselementes (5) von der zweiten mechanischen Verbindungsstelle (10; 12) zum Shimsystem (7) Materialien eingesetzt sind, deren Wärmeleitfähigkeit bei Betriebstemperatur größer ist als 50 W/(mK), insbesondere Kupfer.

8. NMR-Apparatur nach einem der vorhergehenden Ansprüche, **dadurch gekennzeichnet, dass** die Shimelemente (6) als elektrische Spulen und/oder als ferromagnetische Elemente ausgebildet sind.

9. NMR-Apparatur nach einem der vorhergehenden Ansprüche, **dadurch gekennzeichnet, dass** der Vakuumbehälter (8) eine vertikale Raumtemperatur-Bohrung aufweist, in welcher das Shimsystem (7) angeordnet ist, und dass das Positionierungselement (5) einen Klemmring umfasst, wobei die Auflagefläche des Klemmrings auf dem oberen Ende der Raumtemperatur-Bohrung des Vakuumbehälters (8) die zweite mechanische Verbindungsstelle (10) bildet.

10. NMR-Apparatur nach einem der vorhergehenden Ansprüche, **dadurch gekennzeichnet, dass** auf einem Abschnitt des Pfades entlang des Vakuumbehälters (8) von der ersten mechanischen Verbindungsstelle (11) zur zweiten mechanischen Verbindungsstelle (10; 12) und/oder auf einem Abschnitt des Pfades entlang des Positionierungselementes (5) von der zweiten mechanischen Verbindungsstelle (10; 12) zum Shimsystem (7) ein Regulierungselement (13) zur Regulierung thermisch bedingter Längenänderungen auf dem betreffenden Pfad angeordnet ist, das vorzugsweise ein Heizelement und/oder ein Kühlelement und/oder einen Wärmetauscher umfasst.

11. NMR-Apparatur nach Anspruch 10, **dadurch gekennzeichnet, dass** zusätzlich zum Regulierungselement (13) auf dem betreffenden Pfad auch ein Sensorelement (14) angeordnet ist, das vorzugsweise ein Thermometer, insbesondere einen PT-100 Sensor, und/oder ein Dehnungsmesselement umfasst.

12. NMR-Apparatur nach Anspruch 11, **dadurch gekennzeichnet, dass** das Sensorelement (14) einen Laser umfasst, mit welchem mittels einer elektro-optischen Distanzmessung, insbesondere interferometrisch, eine Positionsänderung eines beobachteten Pfad-Abschnitts detektiert werden kann.

13. NMR-Apparatur nach Anspruch 11 oder 12, **dadurch gekennzeichnet, dass** mindestens ein Piezoelement (15) vorhanden ist, mittels dessen eine beobachtete Positionsänderung eines Pfad-Abschnitts korrigiert werden kann.

14. NMR-Apparatur nach einem der vorhergehenden Ansprüche, **dadurch gekennzeichnet, dass** der supraleitende Magnet (1) in einem im Betrieb mit flüssigem Helium gefüllten Heliumbehälter (2) des Kryostaten innerhalb des Vakuumbehälters (8) angeordnet ist, wobei der Heliumbehälter (2) vorzugsweise von einem mit flüssigem Stickstoff gefüllten Stickstoffbehälter (9) des Kryostaten radial umgeben ist.

15. NMR-Apparatur nach einem der vorhergehenden Ansprüche, **dadurch gekennzeichnet, dass** der Kryostat einen Kryokühler umfasst, mittels dessen der supraleitende Magnet (1) auf seine Betriebstemperatur gekühlt werden kann.
